# EUROPEAN PATENT APPLICATION

(11) **EP 2 579 296 A1**
(43) Date of publication of application: **10.04.2013**
(21) Application number: 11789383.4
(22) Date of filing: 21.04.2011
(51) Int. Cl.: H01L 21/02, H01L 21/324, H01L 27/12

(54) **METHOD FOR MANUFACTURING BONDED WAFER**

(30) Priority: 01.06.2010 JP 2010126171
(71) Applicant: Shin-Etsu Handotai Co., Ltd., Tokyo 100-0004 (JP)
(72) Inventor: AGA, Hiroji, Annaka-shi Gunma 379-0196 (JP); OKA, Satoshi, Annaka-shi Gunma 379-0196 (JP); NOTO, Nobuhiko, Annaka-shi Gunma 379-0196 (JP)
(74) Representative: Wibbelmann, Jobst
(86) International application number: PCT/JP2011/002329
(87) International publication number: WO 2011/151968

(57) **Abstract**

The present invention is a method for manufacturing a bonded wafer including: forming an ion-implanted layer in the bond wafer; bonding the bond wafer to a base wafer; delaminating the bond wafer at the ion-implanted layer; and then performing a flattening heat treatment on a surface after the delamination, in which a silicon single crystal wafer, in which a region to form the ion-implanted layer has a resistivity of 0.2 Ωcm or less is used as the bond wafer, the ion-implanted layer is formed in a condition where a dose of the ion for forming the ion-implanted layer is equal to or less than 4×10¹⁶/cm², and the flattening heat treatment on the surface after the delamination is performed by a heat treatment in an atmosphere including HCl gas. As a result, there is provided a method for manufacturing a bonded wafer having a low resistivity thin film (SOI layer) that contains dopant such as boron with high concentration according to the ion implantation delamination method, in which outward diffusion of dopant and suction due to oxidation can be inhibited to maintain low resistivity.

## Description

### TECHNICAL FIELD

The present invention relates to a method for manufacturing a bonded wafer by using an ion implantation delamination method.

### BACKGROUND ART

In a method for manufacturing bonded wafers by the ion implantation delamination method, surface roughness after delamination is insufficient and a damaged layer due to ion implantation remains on a surface after delamination; therefore it is necessary to improve the surface roughness and remove the damaged layer. As a method for improving surface roughness, a method of performing an annealing process under a hydrogen or inert gas atmosphere has been conventionally used to improve the surface roughness (See Patent Documents 1 and 2).

As a method of improving surface roughness and simultaneously removing the damaged layer due to ion implantation, a CMP (Chemical Mechanical Polishing) process has been conventionally performed to improve the surface roughness and thin a film thickness. The CMP process deteriorates a radial distribution of the SOI film thickness due to stock removal distribution of CMP and damages an SOI surface due to CMP. Therefore, a sacrificial oxidation treatment is additionally needed after the CMP process.

Regarding bonded SOI wafers manufactured by the ion implantation delamination method, an SOI wafer having a low resistivity SOI layer or an SOI wafer having an epitaxial layer formed on a low resistivity SOI layer as a seed layer is needed in some cases according to a structural need for devices. In these cases, employing the method for improving the surface roughness by an annealing process under a hydrogen or inert gas atmosphere to flatten a surface after delamination causes outward diffusion of dopant during the annealing process. It is therefore inevitable that the dopant concentration of the SOI layer surface decreases and a desired electrical resistivity cannot be maintained.

When dopant is p-type such as boron, since a suction effect due to segregation of boron into an oxide film is observed in a sacrificial oxidation process for removing the damaged layer, a desired electrical resistivity of the SOI layer cannot be similarly maintained.

In manufacture of an SOI wafer with an SOI layer having normal resistivity (for example, approximately 1 to 10 Ωcm) by the ion implantation delamination method, a method for manufacturing an SOI wafer has been devised in which the surface roughness is improved and simultaneously the resistivity is increased by using the low resistivity bend wafer and performing an annealing process under a hydrogen or reducing atmosphere to induce outward diffusion of boron in the SOI layer after delamination. In this method, however, a long heat treatment is needed for outward diffusion of boron (See Patent Documents 3 and 4).

### CITATION LIST

### PATENT LITERATURE

Patent Document 1:Japanese Unexamined Patent publication (Kokai) No.H10-275905
Patent Document 2:WO2003/009386
Patent Document 3:WO2005/024917
Patent Document 4:Japanese Unexamined Patent publication (Kokai) No.2007-59704

### SUMMARY OF INVENTION

The present invention was accomplished in view of the above-described problems and provides a method for manufacturing a bonded wafer having a low resistivity thin film (SOI layer) that contains dopant such as boron with high concentration according to the ion implantation delamination method, in which outward diffusion of dopant and suction due to oxidation can be inhibited to maintain low resistivity. The present invention also provides a method for manufacturing a bonded wafer in which a bonded wafer with a thin film (SOI layer) having normal resistivity (hereinafter, it represents approximately 1 to 10 Ωcm) can be efficiently manufactured while the surface roughness is improved by utilizing delamination at a low resistivity layer that contains dopant such as boron with high concentration.

### SOLUTION TO PROBLEM

To achieve this object, the present invention provides a method for manufacturing a bonded wafer including: implanting at least either hydrogen gas ions or rare gas ions into a bond wafer from a surface thereof to form an ion-implanted layer in the bond wafer; bonding the ion-implanted surface of the bond wafer to a surface of a base wafer directly or through an insulator film; delaminating the bond wafer at the ion-implanted layer; and then performing a flattening process on a surface after the delamination, in which a silicon single crystal wafer in which at least a region to form the ion-implanted layer has a resistivity of 0.2 Ωcm or less is used as the bond wafer, the ion-implanted layer is formed in a condition where a dose of the ion for forming the ion-implanted layer is equal to or less than 4×10¹⁶/cm², and the flattening process on the surface after the delamination is performed by a heat treatment in an atmosphere including HCl gas.

Use of the silicon single crystal wafer in which at least the region to form the ion-implanted layer has a resistivity of 0.2 Ωcm or less as the bond wafer can reduce a critical dose needed for the delamination when ions are implanted into such a low resistivity region layer compared with a normal resistivity region layer, thereby improving the surface roughness just after the delamination. Therefore, the stock removal of etching (gas etching) in the flattening process that will subsequently be performed can be reduced. The reduced stock removal of the gas etching enables improvement of productivity of the gas etching, reduction in stock removal distribution of the gas etching, and improvement of SOI film thickness distribution.
Furthermore, since the flattening process in the present invention is performed by gas etching in an atmosphere including HCl gas, the flattening can be done for a short time. Therefore, the SOI layer can be thinned for a time shorter than that of outward diffusion of dopant in the SOI layer and the reduction in concentration of dopant such as boron remaining in the SOI layer after the etching can be inhibited.

In the method, the dose of the ion for forming the ion-implanted layer is preferably equal to or more than 2.5×10¹⁶/cm². When the dose is less than 2.5×10¹⁶/cm², there is a risk that the delamination at the ion-implanted layer becomes difficult.

As described above, the dose of the ion for forming the ion-implanted layer in the bond wafer can be no less than 2.5×10¹⁶/cm² and no more than 4×10¹⁶/cm².

In the method, the region to form the ion-implanted layer is preferably a p⁺-type region having a resistivity of 0.003 Ωcm or more.

As described above, the region to form the ion-implanted layer can be a p⁺-type region having a resistivity of 0.003 Ωcm or more. When its resistivity is less than 0.003 Ωcm, it is difficult to manufacture a single crystal wafer with high quality.

In the method, the bond wafer is preferably a p⁺-type silicon single crystal wafer doped with boron or an epitaxial wafer having an epitaxial layer, having a resistivity higher than that of the p⁺-type silicon single crystal wafer, formed on the p⁺-type silicon single crystal wafer.

As described above, in the method for manufacturing a bonded wafer of the present invention, the p⁺-type silicon single crystal wafer doped with boron can be used as the bond wafer. Even when a low resistivity silicon single crystal wafer (p⁺-type silicon single crystal wafer) containing high concentration boron dopant as above, the reduction in concentration of boron remaining in the SOI layer after the etching can be inhibited.
The epitaxial wafer having an epitaxial layer, having a resistivity higher than that of the p⁺-type silicon single crystal wafer, formed on the p⁺-type silicon single crystal wafer doped with boron (a resistivity of 0.2 Ωcm or less and a dopant concentration of 1×10¹⁷/cm³ or more) can also be used as the bond wafer. In this case, implanting ions into the interior of the p⁺-type silicon single crystal wafer can reduces the critical dose, thereby improving the surface roughness after the delamination. Conditions of the heat treatment (gas etching) that is to be performed after the delamination can be thereby relaxed. Therefore, an SOI wafer with a normal resistivity SOI layer having improved surface roughness can be efficiently manufactured by removing the low resistivity layer on the surface after the delamination and leaving the normal resistivity layer only. In addition, the low resistivity layer remaining in the surface after the delamination is rapidly removed by the gas etching and dopant diffusion from the low resistivity layer to the normal resistivity layer is thereby inhibited in comparison with the case of performing a long flattening process under a hydrogen or inert gas atmosphere so that the resistivity of the normal resistivity layer can be inhibited from varying.

Furthermore, the present invention provides a method for manufacturing a bonded wafer including depositing an epitaxial layer on a bonded wafer manufactured by the above-described method for manufacturing a bonded wafer.
When the epitaxial layer is formed, for example, on the surface of a p⁺SOI layer of the SOI wafer subjected to processes up to a flattening heat treatment (gas etching with HCl) to manufacture an SOI wafer having a p⁻/p⁺ structure, the manufactured SOI wafer has both a desired structure and an SOI layer with improved film thickness distribution.

As described above, the present invention can provide a method for manufacturing a bonded wafer having a low resistivity thin film (SOI layer) that contains dopant such as boron with high concentration, in which outward diffusion of dopant and the suction due to oxidation can be inhibited to maintain low resistivity. The method also enables efficient manufacture of a bonded wafer with a thin film (SOI layer) having normal resistivity by utilizing delamination at a low resistivity layer that contains dopant such as boron with high concentration while the resistivity of the normal resistivity layer can be avoided from varying. In addition, according to the present invention, a bonded wafer having improved surface roughness and an SOI layer with good film thickness distribution can be manufactured.

### BRIEF DESCRIPTION OF DRAWINGS

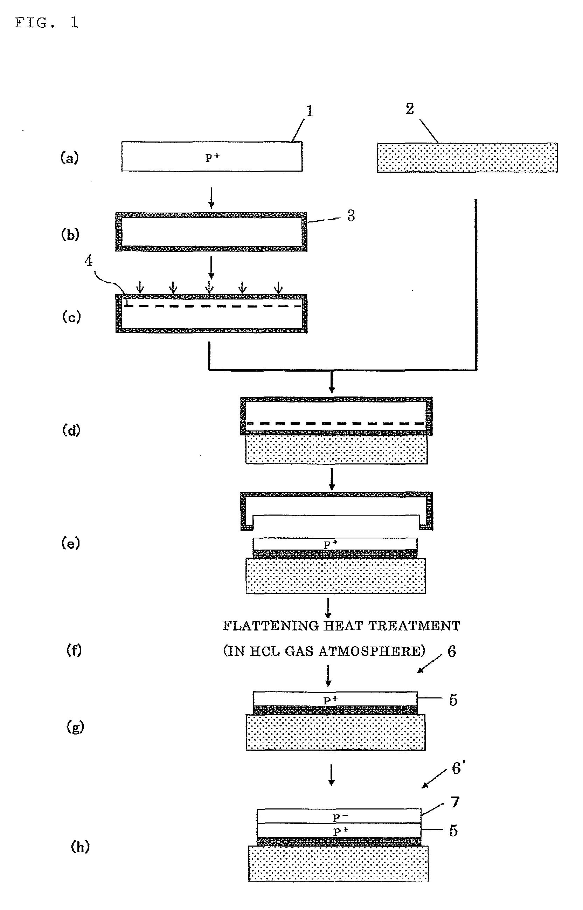

FIG. 1 is a flow chart showing an example of the method for manufacturing a bonded wafer of the present invention.

### DESCRIPTION OF EMBODIMENTS

Hereinafter, the present invention will be more specifically described.
As described above, conventionally there has been a need of the method for manufacturing a bonded wafer having a low resistivity thin film layer according to the ion implantation delamination method, in which outward diffusion of dopant and the suction due to oxidation can be inhibited to maintain low resistivity identical to the bond wafer before a bonding step. The method for manufacturing an SOI wafer has been devised in which the surface roughness is improved and simultaneously the resistivity is increased by using the low resistivity bond wafer and causing outward diffusion of boron in the SOI layer after delamination. This method, however, has a problem in that a long heat treatment is needed for the outward diffusion of boron. There is therefore a need of a method for efficiently manufacturing a bonded wafer having a normal resistivity thin film.

Various studies conducted by the present inventors revealed that the critical dose needed for the delamination when ions are implanted into a low resistivity layer that contains dopant such as boron and phosphorus with high concentration can be reduced compared with a normal resistivity layer. Forming the ion-implanted layer in the low resistivity region accordingly enables reduction in the dose for delamination, thereby improving the surface roughness just after the delamination. As a result, the stock removal of etching (gas etching) in the flattening heat treatment that will subsequently be performed can also be reduced. The reduced stock removal of the gas etching enables improvement of productivity of the gas etching, reduction in stock removal distribution of the gas etching, and improvement of SOI film thickness distribution. Furthermore, since the flattening heat treatment is performed by gas etching in an atmosphere including HCl gas, the flattening can be done for a short time. Therefore, the SOI layer can be thinned for a time shorter than that of outward diffusion of dopant in the SOI layer and the reduction in concentration of boron remaining in the SOI layer after the etching can be inhibited. The present inventors made the above findings, thereby bringing the present invention to completion.

That is, the present invention includes a method for manufacturing a bonded wafer including: implanting at least either hydrogen gas ions or rare gas ions into a bond wafer from a surface thereof to form an ion-implanted layer in the bond wafer; bonding the ion-implanted surface of the bond wafer to a surface of a base wafer directly or through an insulator film; delaminating the bond wafer at the ion-implanted layer; and then performing a flattening process on a surface after the delamination, in which a silicon single crystal wafer in which at least a region to form the ion-implanted layer has a resistivity of 0.2 Ωcm or less is used as the bond wafer, the ion-implanted layer is formed in a condition where a dose of the ion for forming the ion-implanted layer is equal to or less than 4×10¹⁶/cm², and the flattening process on the surface after the delamination is performed by a heat treatment in an atmosphere including HCl gas.

Embodiments of the present invention will be described below with reference to FIG. 1, but the present invention is not limited to these embodiments.
First, as shown in FIG. 1(a), two mirror-polished silicon wafers are prepared to use them as the bond wafer 1 and base wafer 2.
In the method for manufacturing a bonded wafer of the present invention, the ion-implanted layer is to be formed in the interior of the bond wafer 1 in a subsequent step. In the formation of the ion-implanted layer, a silicon single crystal wafer in which at least the region to form the ion-implanted layer has a resistivity of 0.2 Ωcm or less, preferably 0.05 Ωcm or less, more preferably 0.01 Ωcm or less is used as the bond wafer 1. In addition, a silicon single crystal wafer in which the region to form the ion-implanted layer is a p⁺-type region having a resistivity of 0.003 Ωcm or more is preferably used as the bond wafer 1.
FIG. 1(a) illustrates an example of preparing, as the bond wafer 1, a p⁺-type silicon single crystal wafer that is evenly doped with boron throughout.

As shown in FIG. 1(b), when the bond wafer 1 is bonded to the base wafer 2 through an insulator film, the insulator film 3 is formed on at least one of the bond wafer 1 and the base wafer 2. In FIG. 1(b), the insulator film 3 is formed on the bond wafer 1. When the bond wafer 1 is directly bonded to the base wafer 2, it is unnecessary to form the insulator film 3. The thickness of the insulator film 3 and the like is determined on the basis of specifications and not limited in particular. For example, an insulator film 3 (oxide film) having a thickness of approximately 0.01 to 2.0 µm can be formed by thermal oxidization.
The insulator films 3 may be formed either on the bond wafer 1 or on the base wafer 2, and both of these cases enable manufacture. When the low resistivity layer is p-type, a thermal oxide film is preferably formed on the base wafer 2, because the formation prevents reduction in concentration due to the suction of dopant such as boron, thereby maintaining high dopant concentration.

Next, as shown in FIG. 1(c), at least either hydrogen gas ions or rare gas ions are implanted into the bond wafer 1 from the surface of the bond wafer 1 to form the ion-implanted layer 4. In the ion implantation, the resistivity of the region to form the ion-implanted layer 4 is brought to 0.2 Ωcm or less.
The ion-implanted layer 4 is formed in a condition where the dose of the ion for forming the ion-implanted layer 4 is equal to or less than 4×10¹⁶/cm². Moreover, the dose of the ion is preferably equal to or more than 2.5×10¹⁶/cm².
When ions are implanted into the low resistivity layer that contains dopant such as boron with high concentration according to the method for manufacturing a bonded wafer of the present invention, the critical dose needed for the delamination can be reduced compared with the case where ions are implanted into the normal resistivity layer. Forming the ion-implanted layer in the low resistivity region accordingly realizes reduction in the dose for delamination

Next, as shown in FIG. 1(d), the ion-implanted surface of the bond wafer 1 is bonded to the surface of the base wafer 2 through an insulator film 3. The surface of the bond wafer 1 is commonly brought into contact with the surface of the base wafer 2 at room temperature under a clean atmosphere so that the wafers are bonded together without using an adhesive and the like.

Next, as shown in FIG. 1(e), the bond wafer 1 is delaminated at the ion-implanted layer. The delamination method is not limited in particular. For example, the bond wafer 1 can be delaminated by performing a heat treatment on the bonded wafer at approximately 500 to 600°C in an inert gas atmosphere.
As described above, forming the ion-implanted layer 4 in the low resistivity region enables reduction in the dose for the delamination, thereby improving the surface roughness just after the delamination. The stock removal of etching (gas etching) in the later-described flattening heat treatment can also be reduced. The reduced stock removal of the gas etching enables improvement of productivity of the gas etching, reduction in stock removal distribution of the gas etching, and improvement of SOI film thickness distribution.

Next, as shown in FIG. 1(f), the flattening process is performed on the surface after the delamination to obtain the bonded wafer (SOI wafer) 6 (See FIG. 1(g)). In the present invention, the flattening process on the surface after the delamination is performed by a heat treatment in an atmosphere including HCl gas. The heat treatment conditions are not limited in particular. For example, it can be performed at 1000 to 1200°C for 1 to 30 minutes.
In the method for manufacturing a bonded wafer of the present invention, since the surface roughness just after the delamination at FIG. 1(e) is improved, the stock removal distribution of the gas etching in the flattening heat treatment can be reduced and the film thickness distribution of the SOI layer 5 can be improved.
Moreover, since the flattening process is performed by gas etching in an atmosphere including HCl gas, the flattening can be done for a short time. Therefore, the SOI layer 5 can be thinned for a time shorter than that of outward diffusion of dopant in the SOI layer 5 and the reduction in concentration of boron remaining in the SOI layer 5 after the etching can be inhibited.
According to method for manufacturing a bonded wafer of the present invention, the SOI wafer 6 can be obtained in which its resistivity is kept low.

Moreover, the epitaxial layer 7 can be deposited on the SOI wafer 6 obtained in the above manner (See FIG. 1(h)).
More specifically, when the epitaxial layer 7 is formed on the surface of a p⁺-type SOI layer 5 of the SOI wafer 6 subjected to processes up to the flattening heat treatment (gas etching with HCl) to manufacture an SOI wafer 6' having a p⁻/p⁺ structure, the manufactured SOI wafer has an SOI layer with improved film thickness distribution.

In the present invention, the ability to reduce the dose when ions are implanted into the low resistivity layer can be used to manufacture a normal resistivity SOI wafer having improved surface roughness.
In this case, as the bond wafer, the epitaxial wafer having a p⁻/p⁺ structure can be used in which an epitaxial layer having a resistivity higher than that of the p⁺-type silicon single crystal wafer is formed on the p⁺-type silicon single crystal wafer doped with boron. For example, an epitaxial wafer having a p⁻/p⁺ structure can be used in which an epitaxial layer having a resistivity (normal resistivity) higher than that of a low resistivity substrate having a resistivity of 0.003 to 0.2 Ωcm is formed on the substrate.

With such a bond wafer, the ion-implanted layer is formed in the bond wafer after the formation of the insulator film in the above manner. Regarding the ion-implantation depth (implantation position), ions are implanted into a low resistivity region (a region having a resistivity of 0.2 Ωcm or less).
The surface of the epitaxial layer (normal resistivity layer) formed on the bond wafer is then bonded to the base wafer. After delamination, the flattening heat treatment is performed in an atmosphere including HCl gas. The low resistivity layer on the surface after the delamination is removed while only the normal resistivity layer (p⁻epitaxial layer) is left so that an SOI wafer with an normal resistivity SOI layer having improved surface roughness can be manufactured.

According to the method for manufacturing a bonded wafer of the present invention, the critical dose needed for the delamination can be reduced and thereby the surface roughness after the delamination can be improved. Conditions of the heat treatment (gas etching) that is to be performed after the delamination can be thereby relaxed. Therefore, the SOI wafer with the normal resistivity SOI layer having improved surface roughness can be manufactured by removing the low resistivity layer on the surface after the delamination and leaving the normal resistivity layer (epitaxial layer) only. In this case, since the low resistivity layer remaining in the surface after the delamination is rapidly removed by the gas etching, dopant diffusion from the low resistivity layer to the normal resistivity layer is thereby inhibited in comparison with the case of performing a long flattening process under a hydrogen or inert gas atmosphere so that the resistivity of the normal resistivity layer can be inhibited from varying.
It is to be noted that when the dopant diffusion to the normal resistivity layer is allowable, the flattening process can also be performed by a heat treatment in an atmosphere not including HCl gas (a hydrogen gas atmosphere, an inert gas atmosphere, or an atmosphere of a mixed gas thereof). In this case, since the surface roughness after the delamination is improved, the time required for the flattening process can similarly be reduced.

### EXAMPLE

The present invention will be more specifically described below with reference to Experiment, Examples and Comparative Example, but the present invention is not limited thereto.

### (Experiment)

P-type silicon single crystal wafers having an overall resistivity of 10 Ωcm, 0.16 Ωcm, 0.016 Ωcm, and 0.008 Ωcm (doped with boron at a concentration of 1.3×10¹⁵/cm³, 1.4×10¹⁷/cm³, 4.5×10¹⁸/cm³, and 1.1×10¹⁹/cm³, respectively) were prepared as the bond wafers to investigate the relationship between the critical dose and dopant concentration of the ion-implanted layer. After a thermal oxide film having thickness of 150 nm is each formed, ions were implanted into the interior of a silicon bulk through the oxide film. The ion implanting conditions were as follows: a implantation energy of 50 keV; six dose levels in the range of 5.0×10¹⁶ to 2.5×10¹⁶/cm². Then, the bond wafers were each bonded to the base wafers, and the delamination heat treatment was performed at 500°C for 30 minutes to manufacture the SOI wafers. The relationship between the dose and the result of delamination is given in Table 1.

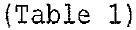

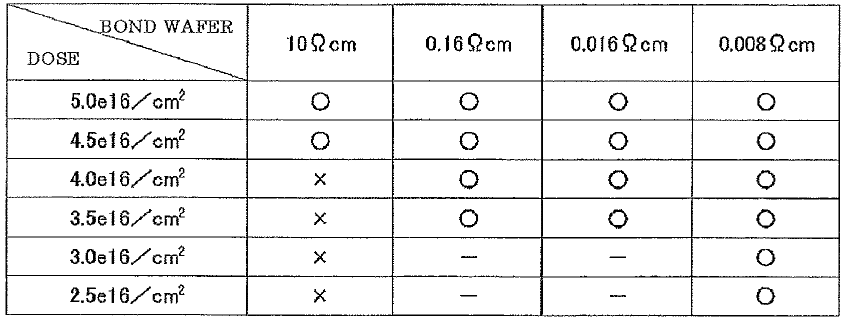

The result given in Table 1 revealed that, when ions were implanted into the low resistivity layer (0.16 Ωcm, 0.016 Ωcm, and 0.008 Ωcm) containing high concentration dopant, the critical dose needed for the delamination can be reduced compared with a normal resistivity layer (10 Ωcm).

### (Example 1(a), Example 1(b), and Comparative Example)

Three SOI wafers in Table 2 described below among the SOI wafers after the delamination manufactured in the above Experiment were thinned by gas etching with HCl. The surface roughness (RMS and R-V) of each wafer is given in Table 2.
When the low resistivity wafer was used as the bond wafer, i.e., when the region to form the ion-implanted layer was the low resistivity bond wafer (Example 1(a) and Example 1(b)), the delamination occurred even with a low dose, and the surface roughness just after the delamination was therefore improved. It was accordingly confirmed that the surface roughness after the flattening heat treatment (gas etching with HCl) on the surface after the delamination was improved more than that in Comparative Example even though the flattening heat treatment was performed in the same conditions.

### <HCl Etching Conditions>

Temperature:1050°C; HCl Flow:400sccm; H₂ Flow:55slm; Time:7 minutes.

**(Table 2)**

| BOND WAFER | | COMPARATIVE EXAMPLE | EXAMPLE 1(a) | EXAMPLE 1(b) |
|---|---|---|---|---|
| | | 10Ω cm | 0.008 Ω cm | 0.008 Ω cm |
| DOSE | | 4.5e16/cm² | 3.5e16/cm² | 4.0e16/cm² |
| GAS ETCHING STOCK REMOVAL | | 185nm | 185nm | 185nm |
| Center | RMS | 0.293nm | 0.251 nm | 0.260nm |
| | P-V | 2.29nm | 2.12nm | 2.15nm |
| Edge | RMS | 0.274nm | 0.215nm | 0.221 nm |
| | P-V | 2.15nm | 1.82nm | 1.88nm |

### (Examples 2 and 3)

Two SOI wafers in Table 3 described below among the SOI wafers after the delamination manufactured in the above Experiment were subjected to the flattening heat treatment (gas etching with HCl) in the same conditions as Example 1(a) and Example 1(b). The boron concentration on the SOI surface was then measured with SIMS (Secondary Ion Mass Spectrometry). The result is given in Table 3.

### (Example 4)

A p-type silicon single crystal wafer having an overall resistivity of 0.008 Ωcm (doped with boron at a concentration of 1.1×10¹⁹/cm³) was prepared as the bond wafer, and ions were implanted into the bulk from its surface. The ion implanting conditions were as follows: a implantation energy of 50 keV; a dose of 4.0×10¹⁶/cm². Then, the bond wafer was bonded to a base wafer with a 150 nm thick thermal oxide film formed on its surface, and the delamination heat treatment was performed at 500°C for 30 minutes to manufacture the SOI wafer. After the flattening heat treatment (gas etching with HCl) was performed in the same conditions as Example 1(a) and Example 1(b), the boron concentration on the SOI surface was measured with SIMS. The result is given in Table 3.

**(Table 3)**

| BOND WAFER | EXAMPLE 2 | EXAMPLE 3 | EXAMPLE 4 |
|---|---|---|---|
| | 0.016 Ω cm | 0.008 Ω cm | 0.008 Ω cm |
| OXIDATION SURFACE | BOND WAFER | BOND WAFER | BASE WAFER |
| BORON CONCENTRATION OF SUBSTRATE | 4.5e18/cm³ | 1.1e19/cm³ | 1.1e19/cm³ |
| ION IMPLANTATION CONDITIONS | 50keV 4.0e16/cm² | 50keV 4.0e16/cm² | 50keV 4.0e16/cm² |
| BORON CONCENTRATION AFTER SOI MANUFACTURE | 1.5e18/cm³ | 2.6e18/cm³ | 8e18/cm³ |

In Examples 2 and 3, since the thermal oxide film was formed on the bond wafer prior to a bonding step, segregation of boron into the thermal oxide film occurred at its formation, and therefore the boron concentration on the SOI layer surface after the SOI wafer manufacture decreased to some extent. This boron concentration on the SOI layer was one digit higher than that in the case where the flattening heat treatment was performed in a hydrogen atmosphere or an inert gas atmosphere for a long time (for example, at 1200°C for one hour). The inhibition effect of the present invention on variation in resistivity (increase in resistivity) of the low resistivity SOI layer was accordingly confirmed. In Example 4, since the thermal oxide film was formed on the base wafer, the variation in SOI layer resistivity was further inhibited.

A p-type epitaxial layer having a resistivity of 1 Ωcm was formed in the following conditions on the surface of the p⁺SOI layer of the SOI wafer that was manufactured in the same conditions as Examples 2 to 4 and subjected to processes up to the flattening heat treatment (gas etching with HCl) to manufacture an SOI wafer having a p⁻/p⁺ structure. The film thickness distribution of the formed SOI layer was ±1.5% in a wafer plane. It was accordingly confirmed that the SOI wafer with good film thickness uniformity was manufactured.

### <Epitaxial Layer Growth Conditions>

Growth Temperature:1080°C; Reaction Time:3 minutes; Epitaxial Layer Film Thickness:3 µm; Reaction Gas:450 sccm dichlorosilane and 53 slm hydrogen gas.

### (Example 5)

An epitaxial wafer with a 100 nm thick epitaxial layer having a resistivity of 1 Ωcm formed on the surface of a silicon single crystal substrate having a resistivity of 0.008 Ωcm was prepared as the bond wafer. Ions were implanted into the bulk of the silicon single crystal substrate through the epitaxial layer. The ion implanting conditions were as follows: an implantation energy of 50 keV; a dose of 4.0×10¹⁶/cm². Then, the bond wafer was bonded to a base wafer with a 150 nm thick thermal oxide film formed on its surface, and the delamination heat treatment was performed at 500°C for 30 minutes to manufacture the SOI wafer. The flattening heat treatment (gas etching with HCl) was further performed at 1050°C to expose the surface of the epitaxial layer so that an SOI wafer having a 70nm thick SOI layer was manufactured. The result of measurement of the boron concentration on the SOI wafer surface by SIMS is given in Table below.
It was confirmed that the resistivity (0.98 Ωcm) of the SOI layer surface was held at approximately the same resistivity (1 Ωcm) when the epitaxial layer was formed.

**(Table 4)**

| BOND WAFER | EXAMPLE 5 |
|---|---|
| | 0.008 Ω cm |
| EPITAXIAL LAYER THICKNESS AND RESISTIVITY | 100nm■ |
| | 1 Ω cm |
| OXIDATION SURFACE | BASE WAFER |
| BORON CONCENTRATION OF SUBSTRATE | 1.1e19/cm³ |
| ION IMPLANTATION CONDITIONS | 50keV, 4.0e16/cm² |
| GAS ETCHING STOCK REMOVAL | 400nm |
| BORON CONCENTRATION AFTER SOI MANUFACTURE (RESISTIVITY) | 1.5e16/cm³ (0.98 Ω cm) |

It is to be noted that the present invention is not limited to the foregoing embodiment. The embodiment is just an exemplification, and any examples that have substantially the same feature and demonstrate the same functions and effects as those in the technical concept described in claims of the present invention are included in the technical scope of the present invention.

## Claims

1. A method for manufacturing a bonded wafer comprising:
implanting at least either hydrogen gas ions or rare gas ions into a bond wafer from a surface thereof to form an ion-implanted layer in the bond wafer;
bonding the ion-implanted surface of the bond wafer to a surface of a base wafer directly or through an insulator film;
delaminating the bond wafer at the ion-implanted layer; and then
performing a flattening process on a surface after the delamination, wherein
a silicon single crystal wafer in which at least a region to form the ion-implanted layer has a resistivity of 0.2 Ωcm or less is used as the bond wafer,
the ion-implanted layer is formed in a condition where a dose of the ion for forming the ion-implanted layer is equal to or less than 4×10¹⁶/cm², and
the flattening process on the surface after the delamination is performed by a heat treatment in an atmosphere including HCl gas.

2. The method for manufacturing a bonded wafer according to claim 1, wherein the dose of the ion for forming the ion-implanted layer is equal to or more than 2.5×10¹⁶/cm²_{.}

3. The method for manufacturing a bonded wafer according to claim 1 or claim 2, wherein the legion to form the ion-implanted layer is a p⁺-type region having a resistivity of 0.003 Ωcm or more.

4. The method for manufacturing a bonded wafer according to any one of claims 1 to 3, wherein the bond wafer is a p⁺-type silicon single crystal wafer doped with boron or an epitaxial wafer having an epitaxial layer formed on the p⁺-type silicon single crystal wafer, the epitaxial layer having a resistivity higher than that of the p⁺-type silicon single crystal wafer.

5. A method for manufacturing a bonded wafer comprising depositing an epitaxial layer on a bonded wafer manufactured by the method for manufacturing a bonded wafer according to any one of claims 1 to 4.
